Europäisches Patentamt

European Patent Office

Office européen des brevets

(11) Veröffentlichungsnummer: **0 290 951**
**A2**

## (12) EUROPÄISCHE PATENTANMELDUNG

(21) Anmeldenummer: **88107198.9**

(22) Anmeldetag: **05.05.88**

(51) Int. Cl.4: **H02M 3/28**

(30) Priorität: 09.05.87 DE 3715528
07.12.87 DE 3741333

(43) Veröffentlichungstag der Anmeldung:
**17.11.88 Patentblatt 88/46**

(84) Benannte Vertragsstaaten:
**AT BE CH DE ES FR GB GR IT LI LU NL SE**

(71) Anmelder: **ZERA ELEKTRISCHE PRÜFGERÄTE CREMER GMBH & CO. KG**
**Hauptstrasse 392**
**D-5330 Königswinter 1(DE)**

Anmelder: **HAMBURGER ELEKTRONIK GESELLSCHAFT MBH**
**Bachstrasse 9-17**
**D-2000 Hamburg 76(DE)**

(72) Erfinder: **Kahmann, Martin, Dipl.-Ing.**
**Am Horstbleek 36**
**D-3300 Braunschweig(DE)**

(74) Vertreter: **Schwarz, Klaus-Jürgen, Dipl.-Ing.**
**Gluckstrasse 7**
**D-5300 Bonn 1(DE)**

(54) Stromwandler-Schaltung.

(57) Die Erfindung betrifft eine Stromwandler-Schaltung, die aus zwei Teilwandlern (W1, W2) besteht, auf die ein zu messender Strom I aufgeteilt wird. Eine geeignete Dimensionierung der Primärwicklungen (3, 4, 5, 6) und eine Verknüpfung der Sekundärsignale beider Teilwandler (W1, W2) bewirkt eine Beseitigung des durch die Stromteilung verursachten Temperatureinflusses auf das Übersetzungsverhältnis der Wandlerschaltung. Eine derartige erfindungsgemäße Schaltung eignet sich insbesondere für Strommeßaufgaben, bei denen ein nicht aufgeteilter Strom im Strommeßwandler eine Sättigungsmagnetisierung verursachen würde. Ein wichtiges Anwendungsbeispiel für die Anordnung sind mischstrombelastbare Prüfzähler für die Elektrizitätszählerprüfung.

FIG.1

## Stromwandler-Schaltung

Die Erfindung betrifft eine Stromwandler-Schaltung, die aus zwei Teilwandlern, die jeweils mehrere Primärwicklungen besitzen, aufgebaut ist.

Stromwandler, insbesondere solche für den Einsatz in Elektrizitätszählern, sollen bei vorgegebener Meßunsicherheit mit möglichst geringem Materialaufwand und möglichst geringer Gleichstromempfindlichkeit realisiert werden. Bei bekannten Stromwandleranordnungen wird die Primärwicklung deshalb so ausgeführt, daß nur ein Teil des zu messenden Primärstromes einen Beitrag zur Durchflutung im Wandlerkern liefert. Dieser kann dann entsprechend kleiner dimensioniert werden.

Es sind Lösungen bekannt, bei denen die Aufteilung dadurch erleichtert wird, daß der Primärwicklung ein sehr niederohmiger Widerstand parallelgeschaltet und somit der Hauptanteil des zu messenden Stromes an dem Wandlerkern vorbeigeführt wird.

Es sind ebenfalls Lösungen bekannt, bei denen eine Reduktion der Durchflutung durch zwei parallelgeschaltete Primärwicklungen mit annähernd gleichem Widerstand aber entgegengesetztem Wicklungssinn erreicht wird.

Alle diese bekannten Anordnungen besitzen den Nachteil, daß bei der Berechnung des jeweiligen Wandler-Übersetzungsverhältnisses die Widerstandswerte der aufgeteilten Primärwicklung und somit deren Instabilitäten in das Ergebnis eingehen.

Der Erfindung liegt die Aufgabe zugrunde, eine Wandleranordnung mit reduzierter Durchflutung zu realisieren, bei der der Widerstand der Primärwicklung ohne Einfluß auf das Meßergebnis bleibt, und die somit auch für sehr genaue Zähler, z.B. sogenannte Prüfzähler für die Prüfung von Haushaltszählern, geeignet ist.

Diese Aufgabe wird erfindungsgemäß durch eine aus zwei Teilwandlern, die jeweils mehrere Primärwicklungen besitzen, aufgebaute Schaltung gelöst, die dadurch gekennzeichnet ist, daß der zu messende Strom I mittels eines Leitwert-Stromteilers in zwei Teilströme mit den Stromstärken $C \cdot I$ und $(1-C) \cdot I$, wobei sich die Konstante C, die auch komplex sein kann, aus den beiden Einzelleitwerten des Stromteilers ergibt, zerlegt wird, daß eine auf den ersten Teilwandler aufgebrachte Primärwicklung mit positivem Wicklungssinn und der Windungszahl W11 von dem Strom $C \cdot I$ durchflossen und eine auf den zweiten Teilwandler aufgebrachte Primärwicklung mit positivem Wicklungssinn und der Windungszahl W21 von dem Strom $(1-C) \cdot I$ durchflossen wird, daß eine andere Primärwicklung des ersten Teilwandlers mit negativem Wicklungssinn und der Windungszahl W12 und eine andere Primärwicklung des zweiten Teilwandlers mit negativem Wicklungssinn und der Windungszahl W22 von dem zu messenden Strom I durchflossen wird, daß für W11 und W12 einerseits und W21 und W22 andererseits Windungszahlen gewählt werden, bei denen in beiden Teilwandlern allein - schon dadurch annähernd Durchflutungsgleichgewicht herrscht, und daß ferner die Sekundärkreise der Teilwandler in einer Weise unterschiedlich dimensioniert werden, bei der durch Addition der beiden Sekundärsignale der Einfluß der Konstante C und damit eine durch die Stromteilung bedingte Instabilität der Übertragungsfunktion der Gesamtanordnung beseitigt wird.

In einer abgewandelten Ausführung der Erfindung kann die gestellte Aufgabe erfindungsgemäß auch durch eine aus Teilwandlern bestehende Wechselstromwandler-Schaltung gelöst werden, deren Primärwicklungen so ausgelegt und verschaltet sind, daß die Wandlerkerne auch beim Vorhandensein primärer Gleichstromanteile keine Sättigungsmagnetisierung erfahren, und die dadurch gekennzeichnet ist, daß der zu messende Strom aufgeteilt in der Weise durch die Primärwicklungen mindestens zweier Teilstromwandler geleitet wird, daß deren Kerne einerseits durch die Stromteilung wählbar schwach durchflutet werden, und daß andererseits die Möglichkeit besteht, durch rechnerische Verknüpfung der von den Sekundärströmen dieser Wandler abgeleiteten Signale ein Signal zu bilden, das proportional zum zu messenden Gesamtstrom ist und aus dem das primäre Stromteilungsverhältnis durch geeignete Dimensionierung der Wandler-Sekundärschaltkreise als Faktor eliminiert werden kann.

Bevorzugte Ausführungsbeispiele der Erfindung sind in der Zeichnung anhand von Schaltbildern schematisch dargestellt. Es zeigen

Fig. 1 eine Schaltung eines elektrischen Stromwandlers in einer ersten Ausführungsform,

Fig. 2 eine Abwandlung der Schaltung von Fig. 2,

Fig. 3 eine weitere Abwandlung einer solchen Schaltung,

Fig. 4 eine weitere abgewandelte Ausführungsform einer solchen Schaltung mit mindestens zwei Teilstromwandlern und

Fig. 5 noch ein demgegenüber weiter abgewandeltes Ausführungsbeispiel.

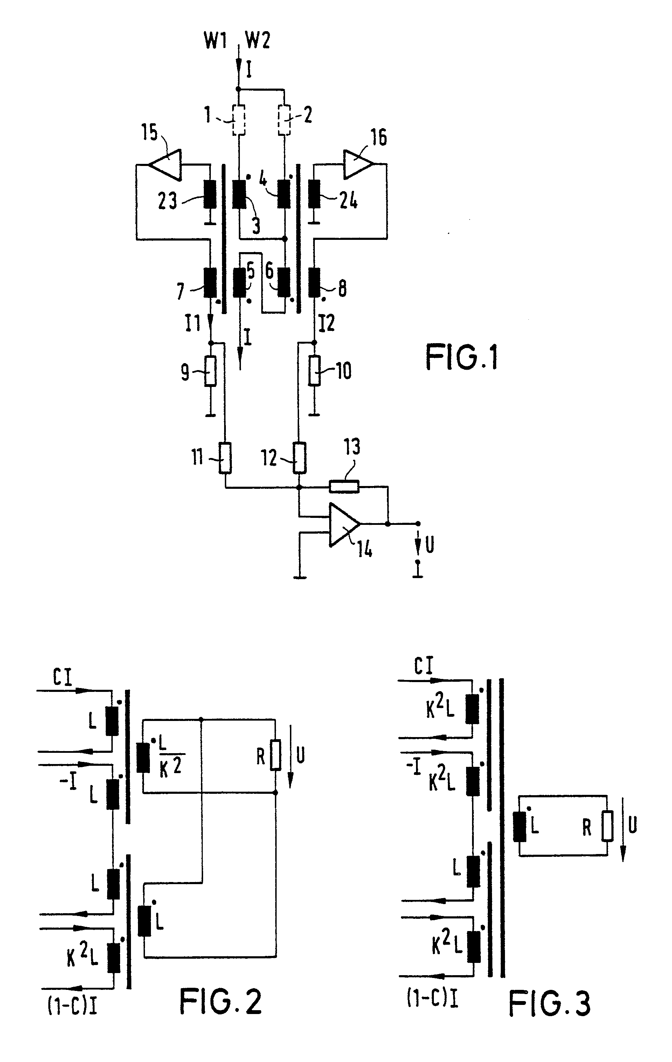

Bei dem Ausführungsbeispiel von Fig. 1 wird der zu messende Strom I durch die unterschiedlichen Wicklungswiderstände 1, 2 der Primärwicklungen 3, 4 mit positivem Wicklungssinn und der Windungszahl W11 bzw. W21 aufgeteilt. Der gesamte Strom I fließt in beiden Teilwandlern W1, W2 weiter in je einer Primärwicklung 5, 6 mit umgekehrtem Wicklungssinn und der Windungszahl W12 bzw. W22. Dadurch kann bei geeigneter Wahl der Windungszahlen W11, W21 der Primärwicklungen 3, 4 und der Windungszahlen W12, W22 der Primärwicklungen 5, 6 in den Kernen beider Teilwandler W1, W2 die resultierende Primärdurchflutung sehr klein gehalten werden. Das bekannte Prinzip der Fehlerkompensation mittels einer Indikatorwicklung 23, 24 und einem Verstärker 15, 16 sorgt in beiden Teilwandlern W1, W2 dafür, daß jeweils Durchflutungsgleichgewicht herrscht und somit die Wandlerübersetzungen allein von den Windungszahlen der aufgebrachten Primärwicklungen 3, 4, 5, 6 und Sekundärwicklungen 7, 8, 23, 24 abhängen. Ein Addierer, der durch drei Widerstände 11, 12, 13 und einen Operationsverstärker 14 gebildet wird, erlaubt es, durch die Addition der Spannungen, die die Ströme I1 und I2 an den Bürdenwiderständen 9, 10 hervorrufen, eine Signalspannung U zu erzeugen, die proportional zum Strom I ist, in der aber die Werte der Wicklungswiderstände und damit deren Temperaturabhängigkeiten nicht auftreten.

Die hierzu erforderliche Dimensionierungsvorschrift für die Windungszahlen, die Widerstandswerte der beiden Bürdenwiderstände 9, 10 und der drei Addierwiderstände 11, 12, 13 läßt sich aus der Gesamtübertragungsfunktion $U = f(I)$ einfach analytisch bestimmen.

Ein besonderer Vorteil der Schaltungsanordnung besteht darin, daß sie aufgrund ihrer besonderen Wirkungsweise, die durch eine spezielle Auslegung der Primärwicklungen einerseits und durch eine rein additive Verknüpfung der Sekundärsignale andererseits erzielt wird, auf der Grundlage beliebiger Wandlerformen, also z.B. Passiv-, Aktiv-, Einkern oder Zweikern-Typen, ausgeführt werden kann. Dabei ist es nicht nur möglich, die Addition der Sekundärsignale, wie in Fig. 1 gezeigt ist, spannungsmäßig vorzunehmen, sondern sie kann auch strommäßig, z.B. wie in Fig. 2 dargestellt ist, durch Parallelschalten von Sekundärwicklungen vollzogen werden. Auch bei der in Fig. 2 - schematisch gezeigten Anordnung zur Messung des Stromes I enthält die am Bürdenwiderstand R abfallende Spannung U keine Komponente durch die Stromteilerkonstante C, die sich aus den Leitwerten des nicht gezeichneten ohmschen Stromteilers ergibt. Um den erwünschten Wegfall des Einflusses von C zu erreichen, müssen die Induktivitäten die Werte L, $L K^2$ und $K^2 L$ besitzen. K ist dabei eine Wicklungskonstante.

Weiterhin ist es möglich, die Addition durchflutungsmäßig zu bewirken. Fig. 3 zeigt hierzu eine Beispielanordnung, bei der das Summieren mittels eines dritten Kerns erreicht wird. Die Nomenklatur entspricht der von Fig. 2.

Schließlich besteht ein weiterer wichtiger Vorteil der erfindungsgemäßen Schaltung darin, daß wegen des rechnerischen Wegfalls von Termen, die die Widerstandswerte der Primärwicklungen enthalten, auf besondere konstruktive Maßnahmen, die der Temperaturabhängigkeit entgegenwirken sollen, verzichtet werden kann.

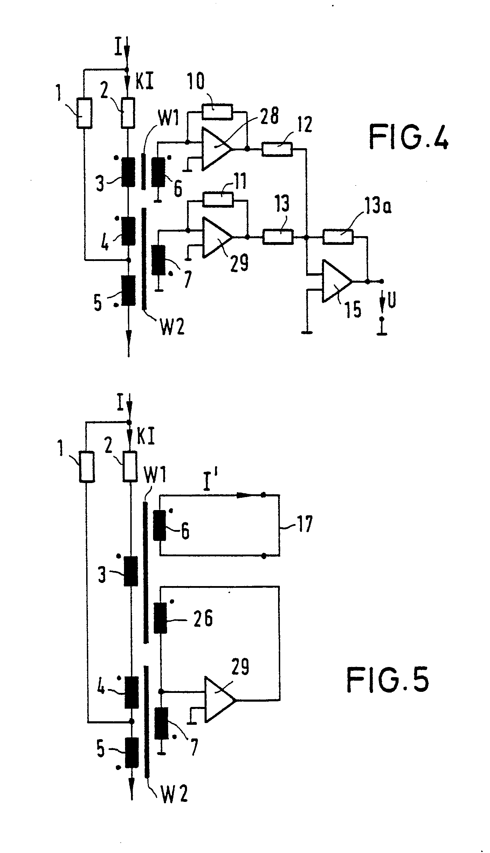

Bei dem weiteren Ausführungsbeispiel von Fig. 4 wird der zu messende Strom I im wesentlichen durch die Widerstände 1, 2 aufgeteilt. Der Teilwandler W1 transformiert den Strom $K \cdot I$, der Teilwandler W2 transformiert die Differenz aus dem Teilstrom $K \cdot I$ und dem Gesamtstrom I in die Sekundärschaltkreise. Die Kombinationen aus einem Operationsverstärker und einem Widerstand 28, 10 und 29, 11 dienen in den Sekundärschaltkreisen jeweils als Strom/Spannungs-Umsetzer. Mit ihrer Hilfe wird dann anschließend durch den aus einem Operationsverstärker 15 und drei Widerständen 12, 13, 13a gebildeten Summierer die erforderliche rechnerische Verknüpfung durchgeführt. Die Spannung U ist dann proportional zum Strom I, während das Verhältnis K der Teilströme bei geeigneter Auslegung der Wicklungswindungszahlen und der Widerstände in dem Sekundärschaltkreis in ihr nicht enthalten ist. Ein günstiges Dimensionierungsbeispiel, bei dem die Durchflutung in beiden Kernen auf etwa 1/10 des Wertes verringert werden kann, den eine Windung mit dem Strom I verursachen würde, erhält man z.B. mit folgenden Werten:

Windungszahl der Wicklung 3: 1
Windungszahl der Wicklung 4: 10
Windungszahl der Wicklung 5: 1
Windungszahl der Wicklung 6 = Windungszahl der Wicklung 7

Widerstand 10 = Widerstand 11
Widerstand 2 ca. 10 mal Widerstand 1
Widerstand 13 = 10 mal Widerstand 12

Durch Berechnung der Funktion $U = f(I)$ läßt sich die Wirkungsweise einfach nachweisen.

Ein weiteres Ausführungsbeispiel zeigt Fig. 5. Die Schaltung der Primärkreise entspricht der in Fig. 4 beschriebenen. In Fig. 5 fungiert jedoch der Operationsverstärker 29 als stromgesteuerte Stromquelle, die die Wicklung 16 speist, welche mit auf den Kern des Teilwandlers W1 aufgebracht ist. Durch diese Schaltung erreicht man, daß die erforderliche rechnerische Verknüpfung auf dem Wege einer Durchflutungsaddition erfolgt. Bei richtiger Auslegung der Windungszahlen ist der Strom I', der die Wicklung 6 und den Strompfad 17 eines Strommmessers durchfließt, proportional zum Strom I, während das Verhältnis K der primären Teilströme im Strom I' dann nicht enthalten ist.

Ein günstiges Dimensionierungsbeispiel, bei dem die Durchflutung auf etwa 1/25 reduziert werden kann, erhält man z.B. mit folgenden Werten:

Windungszahl der Wicklung 3: 1
Windungszahl der Wicklung 4: 25
Windungszahl der Wicklung 5: 1
Windungszahl der Wicklung 6: 500
Windungszahl der Wicklung 7: 500
Windungszahl der Wicklung 26: 20

Durch Berechnung der Funktion $I' = f(I)$ läßt sich auch hier die Wirkungsweise einfach nachweisen.

Ein hervorzuhebender Vorteil der Schaltungsanordnungen besteht darin, daß sie aufgrund ihrer besonderen Wirkungsweise, die durch eine spezielle Auslegung der Primärwicklungen einerseits und durch eine rechnerische Verknüpfung der Sekundärsignale andererseits erzielt wird, auf der Grundlage beliebiger Wandlerformen, also z.B. Passiv-, Aktiv-, Einkern-oder Zweikern-Typen, ausgeführt werden können. Dabei ist es nicht nur möglich, die Verknüpfung der Sekundärsignale, spannungsmäßig, wie in Fig. 4 gezeigt, vorzunehmen, sondern sie kann auch auf der Ebene von Durchflutungen, z.B. wie in Fig. 5 dargestellt ist, oder aber durch Parallelschalten von entsprechend dimensionierten Sekundärwicklungen strommäßig vollzogen werden.

Schließlich besteht ein weiterer wichtiger Vorteil der erfindungsgemäßen Schaltung darin, daß wegen des rechnerischen Wegfalls von Termen, die die Widerstandswerte der Primärwicklungen enthalten, auf besondere konstruktive Maßnahmen, die der Temperaturabhängigkeit entgegenwirken sollen, verzichtet werden kann.

## Ansprüche

1. Stromwandler-Schaltung, die aus zwei Teilwandlern, die jeweils mehrere Primärwicklungen besitzen, aufgebaut ist, **dadurch gekennzeichnet,** daß der zu messende Strom I mittels eines Leitwert-Stromteilers in zwei Teilströme mit den Stromstärken C·I und (1-C)·I, wobei sich die Konstante C, die auch komplex sein kann, aus den beiden Einzelleitwerten des Stromteilers ergibt, zerlegt wird, daß eine auf den ersten Teilwandler (W1) aufgebrachte Primärwicklung (3) mit positivem Wicklungssinn und der Windungszahl W11 von dem Strom C·I durchflossen und eine auf den zweiten Teilwandler (W2) aufgebrachte Primärwicklung (4) mit positivem Wicklungssinn und der Windungszahl W21 von dem Strom (1-C)·I durchflossen wird, daß eine andere Primärwicklung (5) des ersten Teilwandlers (W1) mit negativem Wicklungssinn und der Windungszahl W12 und eine andere Pirmärwicklung (6) des zweiten Teilwandlers (W2) mit negativem Wicklungssinn und der Windungszahl W22 von dem zu messenden Strom I durchflossen wird, daß für W11 und für W12 einerseits und W21 und W22 andererseits solche Windungszahlen gewählt werden, bei denen in beiden Teilwandlern (W1, W2) allein schon dadurch annähernd Durchflutungsgleichgewicht herrscht, und daß ferner die Sekundärkreise der Teilwandler (W1, W2) in einer Weise unterschiedlich dimensioniert werden, bei der durch Addition der beiden Sekundärsignale der Einfluß der Konstante C und damit eine durch die Stromteilung bedingte Instabilität der Übertragungsfunktion der Gesamtanordnung beseitigt wird.

2. Stromwandler-Schaltung nach Anspruch 1, **dadurch gekennzeichnet,** daß die Sekundärsignale in Form von Strömen addiert werden.

3. Stromwandler-Schaltung nach Anspruch 1, **dadurch gekennzeichnet,** daß die Sekundärsignale in Form von aus den Strömen abgeleiteten Spannungen addiert werden.

4. Stromwandler-Schaltung nach Anspruch 1, **dadurch gekennzeichnet,** daß die erforderliche Addition durch Summieren von Durchflutungen in einem weiteren Wandlerkern vollzogen wird.

5. Stromwandler-Schaltung nach einem der Ansprüche 1 bis 4, **dadurch gekennzeichnet,** daß als die beiden Leitwerte des Stromteilers die Wicklungsleitwerke von Primärwindungen verwendet werden.

6. Stromwandler-Schaltung nach einem der Ansprüche 1 bis 4, **dadurch gekennzeichnet,** daß die beiden Leitwerte des Stromteilers aus separaten Widerständen und den Wicklungsleitwerten von Primärwindungen gebildet werden.

7. Stromwandler-Schaltung, insbesondere Wechselstromwandlerschaltung, die aus Teilwandlern (W1, W2) besteht, deren Primärwicklungen (3, 4, 5) so ausgelegt und verschaltet sind, daß die Wandlerkerne auch beim Vorhandensein primärer Gleichstromanteile keine Sättigungsmagnetisierung erfahren, **dadurch gekennzeichnet,** daß der zu messende Strom I aufgeteilt in der Weise durch die Primärwicklungen (3, 4, 5) mindestens zweier Teilstromwandler (W1, W2) geleitet wird, daß deren Kerne einerseits durch die Stromteilung wählbar - schwach durchflutet werden, und daß andererseits die Möglichkeit besteht, durch rechnerische Verknüpfung der von den Sekundärströmen dieser Wandler (W1, W2) abgeleiteten Signale ein Signal zu bilden, das proportional zum zu messenden Gesamtstrom ist, und aus dem das primäre Stromteilungsverhältnis durch geeignete Dimensionierung der Wandler-Sekundärschaltkreise als Faktor eliminiert werden kann.

8. Stromwandler-Schaltung nach Anspruch 7, **dadurch gekennzeichnet,** daß die Sekundärsignale in Form von Strömen rechnerisch verknüpft werden.

9. Stromwandler-Schaltung nach Anspruch 7, **dadurch gekennzeichnet,** daß die Sekundärsignale in Form von aus den Strömen abgeleiteten Spannungen rechnerisch verknüpft werden.

10. Stromwandler-Schaltung nach Anspruch 7, **dadurch gekennzeichnet,** daß die erforderliche rechnerische Verknüpfung mittels Durchflutungen vollzogen wird.

11. Stromwandler-Schaltung nach einem der Ansprüche 7 bis 10, **dadurch gekennzeichnet,** daß als die Leitwerte des Stromteilers die Wicklungsleitwerte von Primärwindungen verwendet werden.

12. Stromwandler-Schaltung nach einem der Ansprüche 7 bis 10, **dadurch gekennzeichnet,** daß die Leitwerte des Stromteilers aus separaten Widerständen und den Wicklungsleitwerten von Primärwindungen gebildet werden.

FIG.1

FIG.2

FIG.3

FIG.4

FIG.5